(19)

**Europäisches Patentamt**
**European Patent Office**
**Office européen des brevets**

(11) **EP 1 569 350 B1**

(12) **EUROPEAN PATENT SPECIFICATION**

(45) Date of publication and mention
of the grant of the patent:
**24.10.2012 Bulletin 2012/43**

(51) Int Cl.:
*H04B 1/707* (2011.01)   *H04B 1/04* (2006.01)
*H04J 13/00* (2011.01)   *H03F 3/24* (2006.01)

(21) Application number: **03776001.4**

(86) International application number:
**PCT/JP2003/015371**

(22) Date of filing: **02.12.2003**

(87) International publication number:
**WO 2004/051876 (17.06.2004 Gazette 2004/25)**

(54) **POWER LIMIT DEVICE AND DIGITAL RADIO TRANSMITTER USING THE SAME**

LEISTUNGSBEGRENZUNGSVORRICHTUNG UND EIN DIESE VERWENDENDER DIGITALER FUNKSENDER

DISPOSITIF DE LIMITATION DE PUISSANCE ET EMETTEUR RADIO NUMERIQUE UTILISANT UN TEL DISPOSITIF

(84) Designated Contracting States:
**DE FI FR GB SE**

(30) Priority: **02.12.2002 JP 2002350157**

(43) Date of publication of application:
**31.08.2005 Bulletin 2005/35**

(73) Proprietor: **NEC Corporation**
**Minato-ku**
**Tokyo 108-8001 (JP)**

(72) Inventor: **NAWATA, Hizuru**
**Minato-ku,**
**Tokyo 108-8001 (JP)**

(74) Representative: **von Samson-Himmelstjerna,**
**Friedrich et al**
**Samson & Partner**
**Patentanwälte**
**Widenmayerstrasse 5**
**80538 München (DE)**

(56) References cited:
**WO-A1-00/33477      WO-A1-00/54428**
**WO-A2-02/13397      JP-A- 2000 244 391**
**JP-A- 2001 036 502   JP-A- 2001 308 723**
**JP-A- 2003 174 370**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**Technical Field**

The present invention relates to a transmitter of a digital radio communication system, and more particularly to a power limiting unit that limits input to a transmission power amplifying unit and a transmitter using thereof.

**Background Art**

On a radio system, it is necessary to minimize the influence of a transmitted wave on adjacent frequency bands from the viewpoint of effective use of radio wave resources. In W-CDMA base stations or the like, particularly, reduction of a transmitter distortion as far as possible is required and thus a high degree of linearity is pursued. In a transmitter, an amplifier is most closely related to the linearity. An amplifier generally has an output saturated more as it comes closer to its maximum output, which resulting in a nonlinear region. In order to attain a high degree of linearity in the amplifier, an operating point is set in a point of the linear region that is sufficiently far away from a nonlinear region. In other words, as a power amplifying unit to be provided in the output stage of the transmitter, an amplifier having an ability to produce an output power more than desired output power (maximum output) is used and operated with a significant backoff from a saturated output power, thereby providing the linearity. That is, a power amplifying unit having an amplification ability many times more than the desired rated power is required. For example, if the backoff of 10dB is needed to obtain a desired distortion characteristic, an amplifier needs to output a power ten times of the desired rated power. This greatly affects equipment costs and also results in increased power consumption, which is not preferable. Therefore, it is desired to operate the system with a minimum backoff.

Meanwhile, if a peak power of an input signal is high, a dynamic range corresponding to the peak is required. When a transmission power amplifying unit is used in a state of low distortion, it is necessary to take a more backoff so as to be suited to its dynamic range for operation at a power rating. As the peak power becomes lower, the dynamic range is accordingly made narrower and thus the backoff can be reduced. For this reason, the power limiting unit that keeps the peak power low is provided in the front stage of the transmission power amplifying unit. There has been employed a method of limiting the peak power with a limiter used as the power limiting unit. This method, however, greatly distorts a signal supplied to the power amplifying unit on which power limitation is carried out by the limiter. As a result, there is a disadvantage that the sidebands of an output signal of the power amplifying unit become wider.

A peak controller of a radio communication system is disclosed in Japanese Laid Open Patent Application (JP-A-Heisei 11-88257). In this conventional example, a power of a transmission orthogonal base band signal is calculated, and the power of the transmission orthogonal base band signal is limited on the basis of the calculated power value. Thus, a peak of a transmission modulation signal is limited with respect to one channel transmission.

In Japanese Laid Open Patent Application (JP-A-Heisei 11-136210), in order to solve a problem in which a limiter threshold level is fixed and it does not cope with a level change in a code multiplex signal, a peak factor is suppressed with an optimal limiter threshold level corresponding to a change in a level of the code multiple signal, thereby providing stable transmission quality. In this conventional example, the limiter acts on the code multiple signal to be sent, a limiter rate calculating section measures a rate of time (limiter rate) during which a signal is outputted with the limiter threshold level, and a limiter threshold level setting section adjusts the limiter threshold level in such a manner that the measured limiter rate comes closer to a predetermined specified limiter rate and provides it to the limiter.

A CDMA transmitting apparatus is disclosed in Japanese Laid Open Patent Application (JP-A-Heisei 11-274983). In this conventional example, components of I axis and Q axis as are each observed change patterns in units of chips in the output of a QPSK diffusion modulator, and the amplitude of a part having a specific change pattern is attenuated by using a weight corresponding to the specific pattern. With this, while the condition for Nyquist transmission is maintained, the amplitude is limited before waveform shaping with prediction of an envelope peak after the waveform shaping.

A CDMA transmitter is disclosed in Japanese Laid Open Patent Application (JP-P2000-106548A). In this conventional example, a peak of transmission data by one symbol is detected. If the peak value is higher than an input limit power of a transmission amplifier, a dummy symbol is generated so as to cancel the detected peak, and the peak is reduced by subtracting the dummy symbol from the transmission data. Additionally, a power correction value is calculated in order to compensate for an amount of a change in power due to the subtraction of the dummy symbol.

A CDMA radio base station is disclosed in Japanese Laid Open Patent Application (JP-P2000-244452A). In this conventional example, distortion is reduced which is generated when a modulation signal with the large number of many carriers and multiplicity so that an individual transmission power is high is supplied to a common amplifier. An instantaneous power and an average power are calculated for every carrier from the input of multiplexed carrier signal of a plurality of channels, and a limit level is set from these instantaneous power and average power. The limiter is controlled for each carrier in the set limit level to correct the amplitude. Thus, the level of a distortion generated in the common amplifier is reduced when the multiplicity is high in number in each carrier and decreased an error rate on the receiving side when the multiplicity is low in number.

A transmission system is disclosed in Japanese Laid Open Patent Application (JP-P2001-86094A). In this conventional example, a region where the linearity of an amplifier is compensated is small and high efficiency and low power consumption is attained. To achieve this, a correction section is provided at the front stage of the ROF section in CDMA system. An instantaneous power is calculated, and the calculated values are compared to a previously set upper limit value. If the calculated value exceeds the upper limit value, the calculated value is detected as an instantaneous peak. Amplitude correction is selectively carried out only when the upper limit value is exceeded.

According to Japanese Laid Open Patent Application (JP-P2001-285088A), a signal obtained by adding a plurality of signals is collectively modulated. The output of the signal obtained by adding the plurality of signals is delayed, the peak value is predicted from the delayed added signal, and the output of the delayed signal is controlled to a predetermined level based on the predicted peak value.

According to Japanese Laid Open Patent Application (JP-P2001-298409A), in cellular communications including at least two services (voice communication service and data communication service, for example), the minimum value and the maximum value of the power level are set for each of the services. The power level is limited by the minimum value and the maximum value for each of the services, and the qualities of the different services are individually adjusted.

According to Japanese Laid Open Patent Application (JP-P2001-339361A), in a multi-carrier communication, the peak power is suppressed while the reduction of transmission efficiency is prevented. One sequence of information signals is converted into a plurality of sequences of information signals, and each of the plurality of sequences of information signals is superimposed on a sequence-specific carrier wave to generate a multi-carrier signal. The peak power of the multi-carrier signal is detected and compared to a threshold. If the peak power exceeds a threshold, the peak is suppressed by superimposing a signal for keeping the peak power low upon a specific one of these carrier waves, instead of the information signal. Thus, a multi-carrier signal is re-generated to suppress the peak.

The application WO 00/33477 A1 describes a peak power regulator that functions within a Code Division Multiple Access (CDMA) transmitter to reduce peak power spikes within baseband signals while maintaining the average output power consistent with the average input power, controlling the out-of-band emissions, and maintaining the in-band signal quality within an acceptable degradation.

**Disclosure of Invention**

Therefore, an object of the present invention is to provide a power limiting apparatus that can reduce a distortion generated in limiting the peak power of an input signal to a power amplifying unit.

Another object of the present invention is to provide a power limiting apparatus in which a dynamic range is made narrow and a backoff is held small by limiting a peak power.

Still another object of the present invention is to provide an inexpensive transmitter in which a backoff to secure linearity required for a transmitter is reduced and power consumption is decreased.

The present invention is defined in the claims.

In an aspect of the present invention, a power limiting apparatus includes a function generating section configured to calculate power values of an input signal and to generate a weighting function for power limitation from the calculated power values, and a delay calculating section configured to delay the input signal and to carry out the power limitation on the delayed input signal by using the weighting function generated by the function generating section.

Here, the function generating section generates the weighting function for a weighting period obtained by adding a predetermined period before and after a position of a peak of the calculated power values which exceeds a threshold, as a center.

In addition, the weighting function has an attenuation coefficient determined in such a manner that a value of the peak of the calculated power values after the power limitation is the threshold and that the calculated power values other than the peak become the threshold or less in the weighting period.

In this case, the weighting function F is expressed as follows:

$$F(t) = 1 - A*\cos(\pi*t/T), \text{ if } |t| \leq T/2, \text{ and}$$

$$= 1, \text{ if } |t| > T/2,$$

where T is the weighting period, and A is the attenuation coefficient.

The function generating section detects a plurality of peaks of the calculated power values exceeding the threshold, sets a weighting period for each of the plurality of maximums, generates the weighting function F in which the attenuation coefficient is determined in such a manner that a value of each of the plurality of peaks becomes the threshold, and generates a final weighting function through multiplication of the weighting functions F.

Here, the function generating section includes a power calculating circuit configured to calculate the calculated power values, a window generating circuit configured to determine the window period, a threshold setting circuit configured to arbitrarily set the threshold for the power limitation, a maximum value detecting circuit configured to monitor the output of the power calculating circuit within the window generated by the window generating circuit and to detect the peaks of the calculated power values outputted from the power calculating circuit and exceeding the threshold set by the threshold setting circuit, and a weighting function generating circuit configured to determine the weighting period for the power limitation and the attenuation coefficient and to generate the weighting functions. The delay operation section includes a delay circuit configured to delay the input signal by a time period necessary to monitor the input signal in the window, and a multiplying circuit configured to weight the input signal delayed by the delay circuit with the weighting functions generated by the weighting function generating circuit.

The input signal may be a complex baseband signal, and the input signal may also be an intermediate frequency signal.

A digital radio transmitter includes any one of the above-described power limiting apparatus, and a digital radio base station includes the digital radio transmitter. Otherwise, a digital radio mobile station may include the digital radio transmitter.

In another aspect of the present invention, a power limiting method of an input signal is attained by calculating power values from the input signal, by determining a window period, by setting a threshold, by monitoring the calculated power values within a window to detect a peak of the calculated power values which exceeds the threshold, by determining a weighting period and an attenuation coefficient to generate a weighting function, by delaying the input signal by the window period, and by multiplying the weighting function and the delayed input signal.

In the generating the weighting function, the weighting period is determined to have a period obtained by adding a predetermined period before and after a position of the peak of the calculated power values as a center. Additionally, in the generating the weighting function, the attenuation coefficient is determined in such a manner that a value of the peak of the calculated power values after the power limitation is the threshold and that values of the calculated power values other than the peak are the threshold or less in the weighting period.

Moreover, in the generating the weighting function, the following function F is generated:

$$F(t) = 1 - A*\cos(\pi*t/T), \text{ if } |t| \leq T/2, \text{ and}$$
$$= 1, \text{ if } |t| > T/2,$$

where T is the weighting period and A is the attenuation coefficient.

The detecting the maximum value is achieved by detecting a plurality of peaks of the calculated power values exceeding the threshold. The generating the weighting function is achieved by setting the weighting period for each of the plurality of detected peaks, by determining the attenuation coefficient in such a manner that a value of each of the plurality of peaks is the threshold, by determining the weighting function for the weighting period by using the attenuation coefficient, and by generating the weighting function from a multiplication of the determined weighting functions.

**Brief Description of Drawings**

Fig. 1 is a diagram showing a configuration of a transmitter of a digital radio communication system according to a first embodiment of the present invention;

Fig. 2 is a diagram showing a configuration of a power limiting unit used in the transmitter of Fig. 1;

Figs. 3A and 3B are diagrams showing examples of input and output power waveforms in power limitation;

Fig. 4 is a diagram showing a configuration of the transmitter of the digital radio communication system according to a second embodiment of the present invention;

Fig. 5 is a diagram showing a configuration of the power limiting unit used in the transmitter indicated in Fig. 4; and

Figs. 6A and 6B are diagrams showing examples of input and output power waveforms in the power limiting unit.

**Best Mode for Carrying Out the Invention**

A transmitter using a power limiting unit of the present invention will be described in detail with reference to the attached drawings.

[First Embodiment]

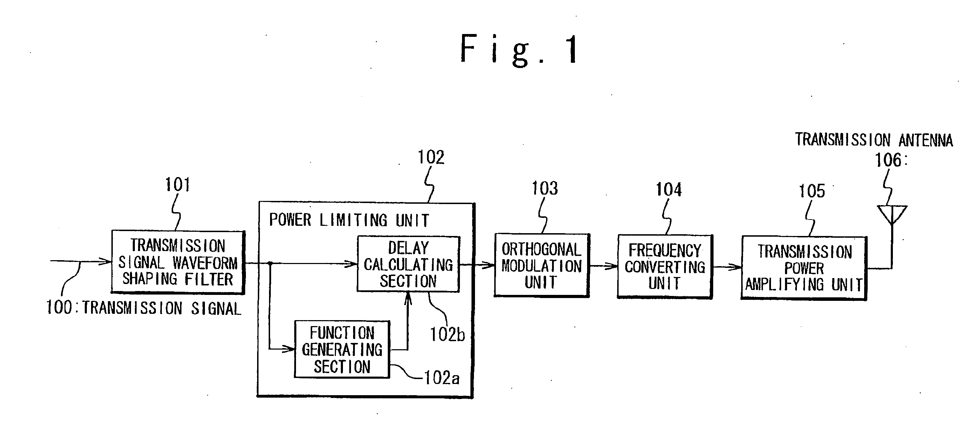

Fig. 1 is a block diagram showing a configuration of a transmitter in a digital radio communication system according to the first embodiment of the present invention. The transmitter includes a transmission waveform shaping filter 101, a power limiting unit 102 having a function generating section 102a and a delay calculating section 102b, a orthogonal modulation unit 103, a frequency converting unit 104, a transmission power amplifying unit 105, and a transmission antenna 106.

An input transmission signal 100 is a complex baseband signal composed of an in-phase signal (generally to be referred to as Ich) and an orthogonal signal (generally to be referred as Qch), and is supplied to the transmission waveform shaping filter 101. The transmission waveform shaping filter 101 carries out waveform shaping on the complex baseband signal 100 and outputs a shaped complex baseband signal 201 to the power limiting unit 102. In the power limiting unit 102, the function generating section 102a generates a weighting function for power limitation from a power calculation value of the shaped complex baseband signal. The delay calculating section 102b carries out a power limiting operation on the delayed shaped complex baseband signal using the weighting function, and outputs the operation result to the orthogonal modulation unit 103. The orthogonal modulation unit 103 carries out orthogonal modulation on the in-phase signal and the orthogonal signal in the power limited complex signal to form an intermediate frequency signal, and sends it to the frequency converting unit 104. The frequency converting unit 104 carries out frequency conversion on the orthogonal-modulation signal to form a high frequency signal. The frequency-converted high-frequency signal is power-amplified by the transmission power amplifying unit 105, and then radiated as a radio wave signal from the antenna 106.

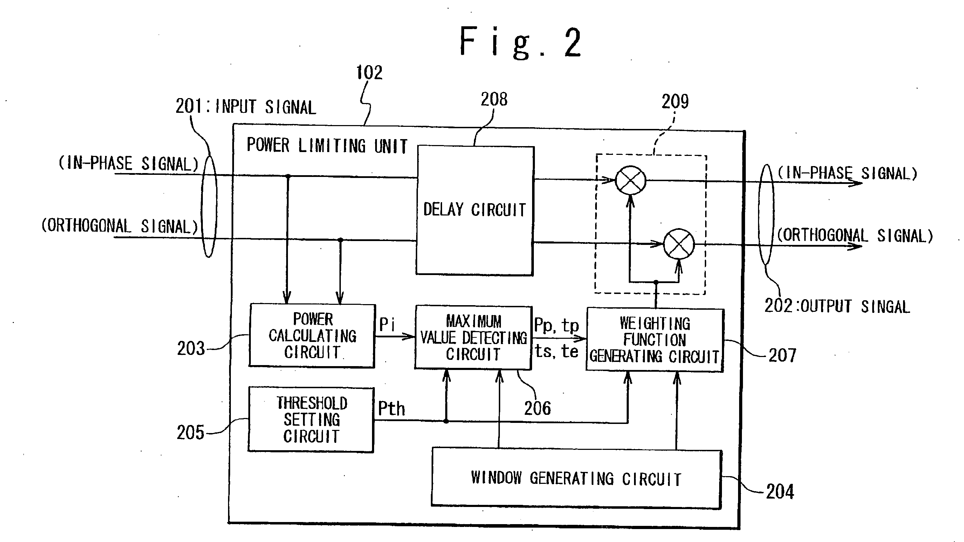

Referring to Fig. 2, the configuration of the power limiting unit in the first embodiment of the present invention will be described. In the power limiting unit 102, the function generating section 102a includes a window generating circuit 204, a threshold setting circuit 205, a power calculating circuit 203, a maximum value detecting circuit 206, and a weighting function generating circuit 207. The delay calculating section 102b includes a delay circuit 208 and multiplying circuits 209.

The shaped complex baseband signal 201 is supplied to the delay circuit 208 and the power calculating circuit 203. The delay circuit 208 delays the shaped complex baseband signal 201 by a predetermined time of a predetermined window ($T_w$). Also, the power calculating circuit 203 calculates the power values of the shaped complex baseband signal 201 as a vector sum of the complex signal, and outputs the calculated power values to the maximum value detecting circuit 206.

A threshold $P_{th}$ indicating a criterion for determining whether to impose power limitation or not can be set to an arbitrary value. The threshold setting circuit 205 holds a threshold depending on the situation, and notifies the threshold to the maximum value detecting circuit 206 and the weighting function generating circuit 207.

The maximum value detecting circuit 206 receives the calculated power values from the power calculating circuit 203, and observes a window generated by the window generating circuit 204 to detect a maximum peak corresponding to the calculated power values exceeding the threshold $P_{th}$ notified by the threshold setting circuit 205. The detected maximum value $P_p$, a time $t_p$ corresponding to the maximum peak value in the window, and a time period ($t_s$ to $t_e$) during which the calculated power values exceed the threshold $P_{th}$ are sent to the weighting function generating circuit 207.

The weighting function generating circuit 207 calculates an attenuation coefficient A based on the maximum peak value from the maximum value detecting circuit 206 and the threshold $P_{th}$ set by the threshold setting circuit 205. Also, the weighting function generating circuit 207 sets a weighting period T from the time corresponding to the maximum peak value sent from the maximum value detecting circuit 206 and the time period during which the calculated power values exceed the threshold, with reference to the time of the window generated by the window generating circuit 204. Moreover, the weighting function generating circuit 207 generates a weighting function as a function of the attenuation coefficient A, the weighting period T and the maximum value time $t_p$, and sends the weighting function to the multiplying circuit 209.

On the other hand, the delay circuit 208 delays the shaped complex baseband signal 201 by the window time $T_w$, and then outputs the delayed signal 201 as a delayed complex baseband signal to the multiplying circuit 209. The multiplying circuit 209 multiplies the delayed complex baseband signal and the weighting function, and outputs a power-limited output signal 202.

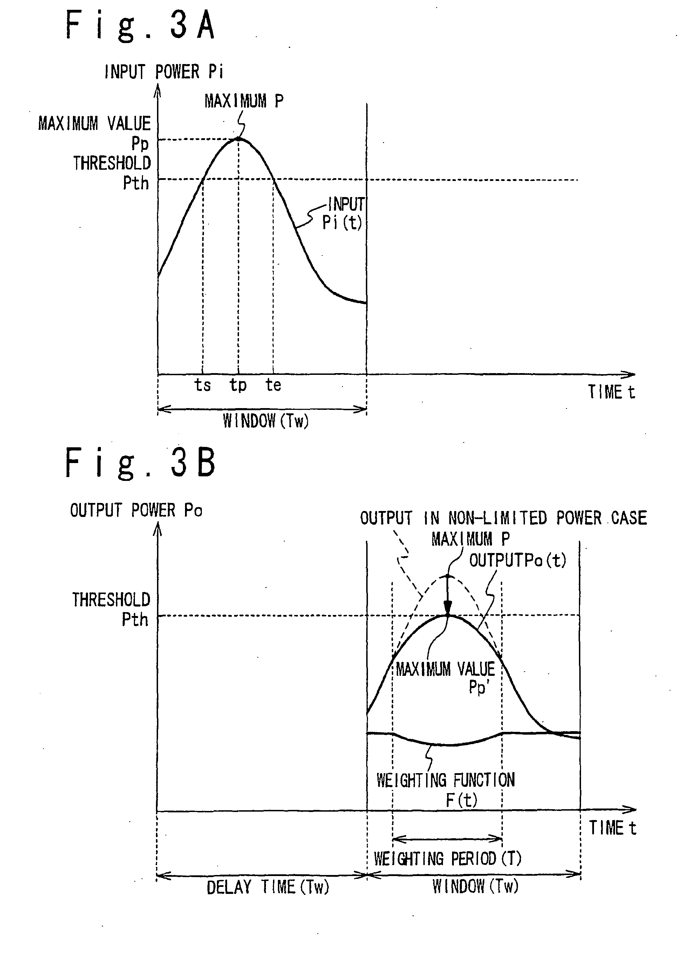

Figs. 3A and 3B show examples of input and output power waveforms of the power limiting unit. By using these waveforms, an example of operation of the power limiting unit when a single maximum is included in the window will be described. The input complex baseband signal 201 is supplied to the power limiting unit 102 of Fig. 2. The power calculating circuit 203 carries out power calculation of the input complex baseband signal 201. Also, the input complex baseband signal 201 is delayed by the delay circuit 208. The output of the power calculating circuit 203 corresponds to input power values $P_1$ (t).

In the period of the window $T_w$ generated by the window generating circuit, the maximum value detecting circuit 206 observes the presence or absence of a maximum peak of the input power values $P_i$ that exceed the threshold $P_{th}$. In Fig. 3A, the maximum peak value exceeding the threshold $P_{th}$ is the maximum value $P_p$ in an in-window relative time $T_p$. The maximum value detecting circuit 206 sends the time $t_p$, the maximum peak value $P_p$ and the threshold exceeding time period $t_s$ to $t_e$ where the power values exceed the threshold $P_{th}$, to the weighting function generating circuit 207.

The weighting function generating circuit 207 generates a weighting function F(t) based on the relative time $t_p$ of the maximum point within the window detected by the maximum value detecting circuit 206, the maximum value $P_p$, the threshold exceeding time period $t_s$ to $t_e$ where the power values exceed the threshold $P_{th}$, and the threshold $P_{th}$ set by the threshold setting circuit. The attenuation coefficient A is expressed based on the maximum value $P_p$ and the threshold $P_{th}$ as follows.

$$A = 1 - P_{th} / P_p$$

The weighting period T is set with the maximum point as a center. In addition, the weighting period T is set as a period containing the threshold exceeding time period $t_s$ to $t_e$ at least so that the output after the weighting does not exceed the threshold within the weighting period.

As a method of setting the weighting period, for example, of the end points of the interval $t_s$ and $t_e$, an end point $t_x$ more distant from the maximum point $t_p$ is determined, and a period of two times of $t_x$ is set as a weighting period before and after the maximum point $t_p$ in such a manner that power variations are smoothed, i.e., $(t_p \pm (t_p - t_x) \times 2)$. Accordingly, the weighed period T is expressed as follows.

$$T = Max (t_p - t_s, t_e - t_p) \times 4$$

Also, as another method of setting the weighting period, a threshold for setting the weighting period (a period setting threshold) is predetermined in addition to the threshold as a criterion for limiting the input power, and a period during which the calculated power values exceed the period setting threshold is used. For example, it is supposed that the end points of the period during which the calculated power values exceed the period setting threshold are $t_s$ and $t_e$. The end point $t_x$, more distant from the maximum point $t_p$, of the end points $t_s$ and $t_e$ of the period is determined, and a period having the period of $t_x$ before and after the maximum point $t_p$ is set as the weighting period. That is to say, assuming that

$$T = Max (t_p - t_s, t_e - t_p) \times 2,$$

the weighting period is set in $t_p \pm (t_p - t_x)$. When the attenuation coefficient A and the weighting period T have been determined, the weighting function F(t) is determined as follows:

$$F(t) = 1 - A*cos (\pi*(t - t_p)/T), \text{ if } |t - t_p| \leq T/2, \text{ and}$$

$$= 1, \text{ if } |t - t_p| > T/2.$$

In this manner, the maximum value after the power limitation can be set so that it becomes the same value as the threshold $P_{th}$.

The weighting function generating circuit 207 outputs the weighting function F (t) in synchronization with the delayed input signal as the other input of the multiplying circuit 209, in accordance with the timing of the window generated by the window generating circuit 204. The multiplying circuit 209 multiplies the complex signal delayed by the window time $(T_w)$ by the delay circuit 208 and the weighting function generated by the weighting function generating circuit 207, and outputs the result as a power-limited complex signal. Assuming that the calculated power values of the delayed complex signal are $P_i'(t)$, a calculated power value $P_o(t)$ of the output signal is expressed as follows:

$$P_o(t) = P_i'(t) * F(t - t_p).$$

As shown as the output power $P_o(t)$ in Fig. 3B, the maximum value $P_p'$ is power-limited to the same value as the threshold $P_{th}$ ($P_p' = P_{th}$). The time $t_p$ of the maximum point in the output is a relative time within the window, and an absolute time is delayed by the window time $T_w$ with respect to the relative time $t_p$ within the window at the time of input. As mentioned above, the power limiting unit 102 can limit input power signal exceeding the threshold to the threshold or less and output the power-limited input power signal to the orthogonal modulation unit 103.

[Second Embodiment]

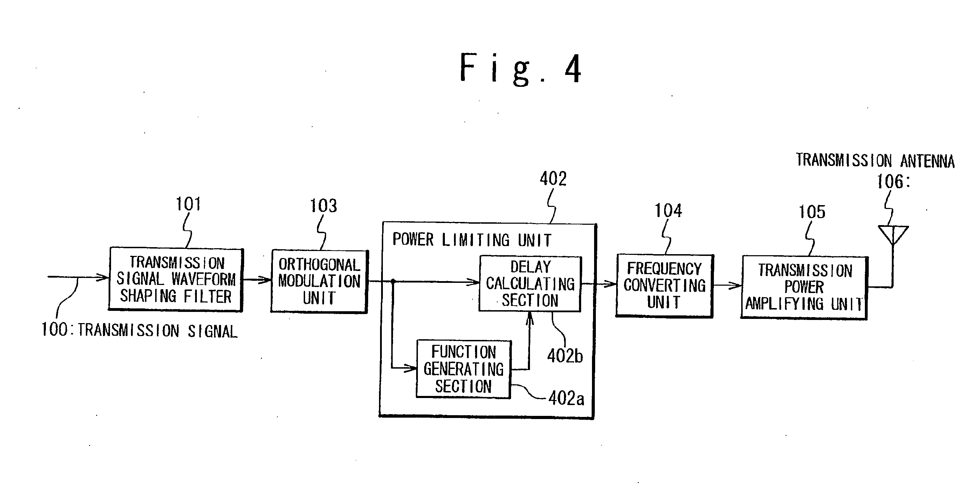

Fig. 4 is a block diagram showing a configuration of the transmitter in the digital radio communication system according to the second embodiment of the present invention. Components identical with or corresponding to those of the first embodiments are allocated with the same reference numerals to omit detailed descriptions on them. The transmitter includes the transmission waveform shaping filter 101, the orthogonal modulation unit 103, a power limiting unit 402 composed of a function generating section 402a and a delay calculating section 402b, the frequency converting unit 104, the transmission power amplifying unit 105, and the transmission antenna 106.

The transmission signal 100 is converted into an intermediate frequency signal 501 in the orthogonal modulation unit 103 through the transmission waveform shaping filter 101, and sent to the power limiting unit 402. The power limiting unit 402 uses a weighting function generated by the function generating section 402a to carry out a power limiting operation by the delay calculating section 402b, and sends the power-limited intermediate frequency signal to the frequency converting unit 104. The frequency converting unit 104 converts it into a high-frequency signal and the transmission power amplifying unit 105 amplifies the power of the signal, and the amplified signal is radiated from the antenna 106.

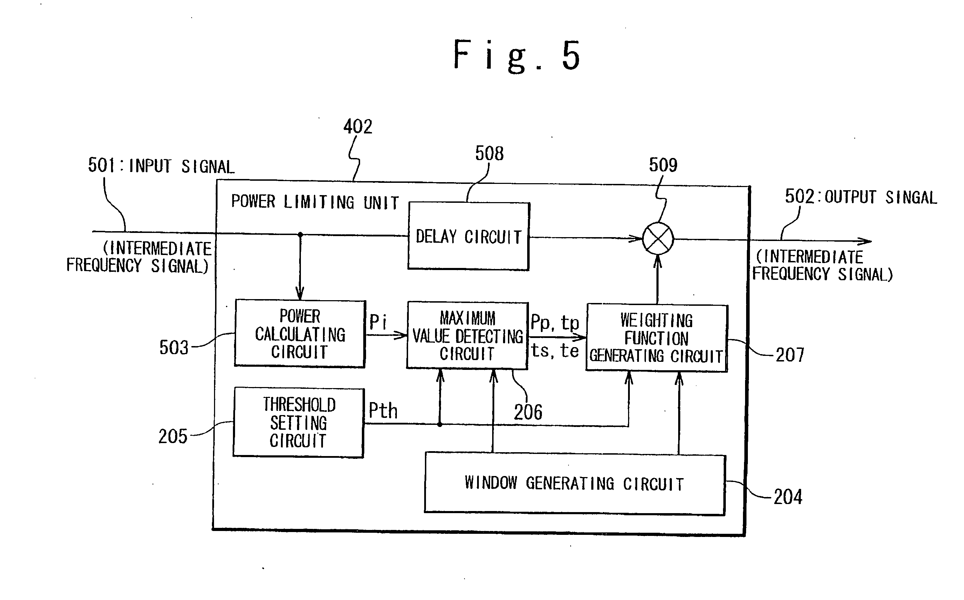

Fig. 5 shows a structure of the power limiting unit in the second embodiment of the present invention. The power limiting unit 402 has the function generating section 402a and the delay calculating section 402b. The function generating section 402a includes the window generating circuit 204, the threshold setting circuit 205, a power calculating circuit 503, the maximum value detecting circuit 206, and the weighting function generating circuit 207. The delay calculating section 402b includes a delay circuit 508 and a multiplying circuit 509. In the configuration shown in Fig. 4, the power limiting unit 402 is provided between the orthogonal modulation unit 103 and the frequency converting unit 104, and an input signal of the power limiting unit 402 is the intermediate frequency signal 501.

The input intermediate frequency signal 501 is supplied to the delay circuit 508 and the power calculating circuit 503. The delay circuit 508 delays the input intermediate frequency signal 501 by a predetermined window time ($T_w$), and outputs it as a delayed intermediate frequency signal to the multiplier 509. The power calculating circuit 503 calculates the power values of the input intermediate frequency signal 501 and outputs the calculated power values to the maximum value detecting circuit 206. Instead of the power values in a strict sense, values corresponding to the power such as a maximum amplitude and average amplitude of the signal may be used. In this case, the output values from the threshold setting circuit 205 that sets a threshold as a criterion for determination, and the power values in the maximum value detecting circuit 206 that uses the output of the power calculating circuit 503 and the power values in the weighting function generating circuit 207 has the same measures. Meanwhile, the threshold setting circuit 205 determines the threshold $P_{th}$ as a criterion for imposing power limitation, and sets the threshold $P_{th}$ to the maximum value detecting circuit 206 and the weighting function generating circuit 207.

The maximum value detecting circuit 206 receives the calculated power values from the power calculating circuit 503 and observes the window generated by the window generating circuit 204 to detect maximum peak points of the calculated power values that exceeds the threshold $P_{th}$ set by the threshold setting circuit 205. Also, the maximum value detecting circuit 206 sends the detected maximum peak values and times for the maximum peak value, and the period of the calculated power values exceeding the threshold, to the weighting function generating circuit 207. The weighting function generating circuit 207 generates the weighting function from each of the maximum peak value, the time for the maximum peak value and the period of the calculated power values exceeding the threshold sent from the maximum value detecting circuit 206 and the threshold set by the threshold setting circuit 205 based on the window time, and sends the weighting function to the multiplying circuit 509. The multiplying circuit 509 multiplies the delayed intermediate frequency signal from the delay circuit 508 and the weighting function, and outputs a power-limited transmission signal.

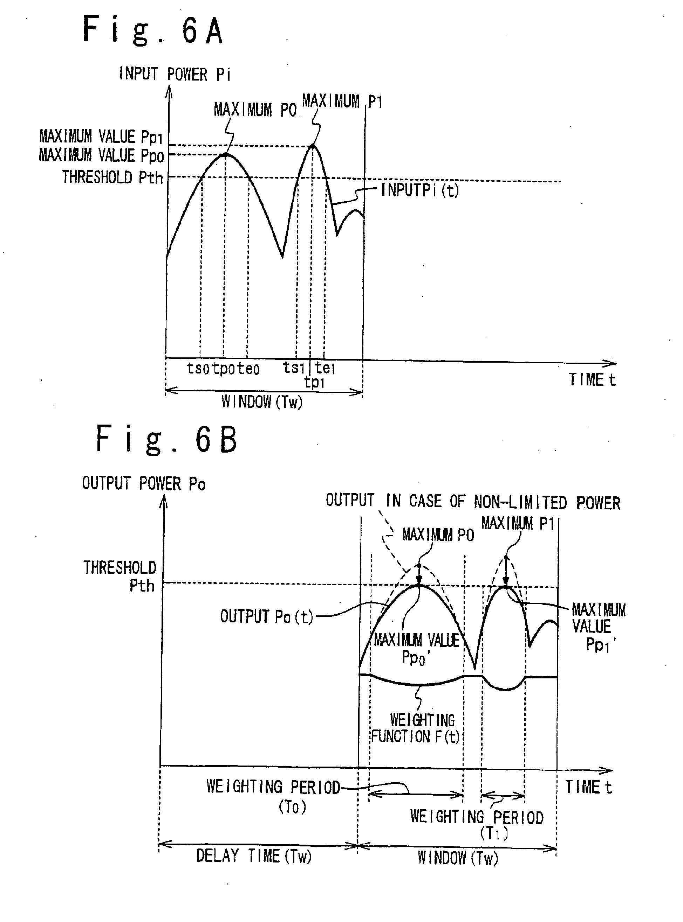

Using the examples of input and output power waveforms of Figs. 6A and 6B, an example of an operation of the power limiting unit will be described when a plurality of maximums are included in the window. The intermediate frequency signal 501 is supplied to the power limiting unit 402 of Fig. 5. The intermediate frequency signal 501 is subjected to power calculation by the power calculating circuit 503 and delayed by the delay circuit 508. The output of the power calculating circuit 503 corresponds to calculated power values $P_i(t)$ shown in Fig. 6A.

The maximum value detecting circuit 206 observes the calculated power values $P_i$ during the window time $T_w$ to detect maximum peak values exceeding the threshold $P_{th}$. In Fig. 6A, there exist two maximum peaks, a maximum peak $P_0$ and a maximum peak $P_1$. The maximum peak $P_0$ has a maximum peak value $P_{p0}$ in an in-window relative time $t_{p0}$, and the maximum peak $P_1$ has a maximum peak value $P_{p1}$ in an in-window relative time $t_{p1}$. The maximum value detecting circuit 206 sends data of the maximum peak values (the time $t_{p0}$ and maximum peak value $P_{p0}$ with respect to the maximum peak $P_0$, and the time $t_{p1}$ and maximum peak value $P_{p1}$ with respect to the maximum peak $P_1$) and data of the periods of the calculated power values exceeding the threshold (end-point times $t_{s0}$ and $t_{e0}$ with respect to the maximum peak $P_0$, and end-point times $t_{s1}$ and $t_{e1}$ with respect to the maximum peak $P_1$) to the weighting function generating circuit 207. The weighting function generating circuit 207 firstly determines the weighting function for each of the maximum peaks $P_0$ and $P_1$ in the window. With respect to the maximum peak $P_0$, a weighting function $F_0(t)$ is determined using the data of the maximum peak value (time $t_{p0}$, maximum peak value $P_{p0}$) and the data of the period of the calculated power values exceeding the threshold ($t_{s0}$, $t_{e0}$). An attenuation coefficient $A_0$ is represented from the maximum peak value $P_{p0}$ and threshold $P_{th}$ as follows:

$$A_0 = 1 - P_{th} / P_{p0}.$$

A weighting period To with the maximum peak in a center is determined like the first embodiment, and the post-weighting output is set in the period so as not to excess the threshold. From the attenuation coefficient $A_0$ and the weighting period $T_0$, the weighting function $F_0(t)$ for the maximum peak $P_0$ is determined as follows:

$$F_0(t) = 1 - A_0.\cos(\pi*(t - t_{p0})/T_0), \text{ if } |t - t_{p0}| \le T_0/2, \text{ and}$$

$$= 1, \text{ if } |t - t_{p0}| > T_0/2,$$

where $A_0 = 1 - P_{th}/P_{p0}$.
The maximum peak value $P_{p0}'$ of the maximum peak $P_0$ after power limitation becomes the same value as the threshold ($P_{p0}' = P_{th}$).
Likewise, the weighting function $F_1(t)$ for the maximum peak $P_1$ is determined as follows:

$$F_1(t) = 1 - A_1.\cos(\pi*(t - t_{p1})/T_1), \text{ if } |t - t_{p1}| \le T_1/2, \text{ and}$$

$$= 1, \text{ if } |t - t_{p1}| > T_1/2,$$

where $A_1 = 1 - P_{th}/P_{p1}$.
The maximum peak value $P_{p1}'$ of the maximum peak $P_1$ after power limitation becomes also the same as the threshold $P_{th}$ ($P_{p1}' = P_{th}$).
When a plurality of maximum peaks are included in the window, a final weighting function is found as a multiplication of the weighting function for the maximum peaks. Thus, the final weighting function F(t) generated by the weighting function generating circuit 207 is expressed as follows:

$$F(t) = F_0(t - t_{p0}) * F_1(t - t_{p1}).$$

When more maximums exist, the final weighting function is determined in the same manner.

The generated weighting function F (t) is outputted to the weighting function generating circuit 207 in synchronization with the delayed intermediate frequency signal in accordance with the timing of the window generated by the window generating circuit 204. In this manner, the multiplying circuit 509 multiplies the intermediate frequency signal delayed by the delay circuit 508 by the window time ($T_w$) and the weighting function generated by the weighting function generating circuit 207, and outputs the result as a power-limited intermediate frequency signal. Assuming that the calculated power values of the delayed intermediate frequency signal are $P_i'$ (t), the calculated power values of the output signal $P_o$ (t) are expressed as follows:

$$P_o(t) = P_i'(t) * F(t - t_p)$$
$$= P_i'(t) * F_0(t - t_{p0}) * F_1(t - t_{pi}).$$

As shown by the output power values $P_o$ (t) in Fig. 6B, each of the maximum values can be power-limited by the power limiting unit 402 to the same value as the threshold $P_{th}$.

Figs. 6A and 6B present cases where two maximums exist in the window. However, in case that three or more maximums are detected, in the same manner, a multiplication of the weighting functions for the maximums is sent as a weighting function generated by the weighting function generating circuit to the multiplying circuit. If n maximums are detected, the weighting function is represented by the following expression:

$$F(t) = F_0(t - tp_0) * F_1(t - t_{p1}) * \ldots * F_i(t - t_{pi}) * \ldots F_{n-1}(t - t_{pn-1})$$

$$F_i(t) = 1 - Ai * \cos(\pi * (t - t_{pi})/T_i), \text{ if } |t - t_{pi}| \leq T_i/2, \text{ and}$$
$$= 1, \text{ if } |t - t_{pi}| > T_i/2,$$

where $A_i = 1 - P_{th}/P_{pi}$, and i = 0, 1, ..., n-1.

Consequently, the power limiting unit 402 limits the power of the input signal exceeding the threshold and containing a plurality of maximum peaks to the threshold or less, and outputs it to the frequency converting unit 104.

According to the present invention, it is possible to reduce a distortion that occurs in limiting the peak power of an input signal to the power amplifying unit.

As described above, according to the present invention, it is possible to narrow a dynamic range and to reduce a backoff by limiting the peak value.

Moreover, according to the present invention, it is possible to provide an inexpensive digital radio transmitter with power consumption lowered through the operation of a reduced backoff in which the linearity required for the transmitter is secured. Such a digital radio transmitter (not shown) may be used at a digital radio base station (not shown) or a digital radio mobile station (not shown).

**Claims**

1. A power limiting apparatus comprising:

a function generating section (102a, 402a) configured to calculate power values of an input signal and to generate a final weighting function from said calculated power values; and
a delay calculating section (102b, 402b) configured to delay said input signal and to carry out power limitation on the delayed input signal by multiplying the delayed input signal by said final weighting function,
wherein said function generating section generates said weighting function for a weighting period obtained by adding predetermined periods before and after a position of each of peaks of said calculated power values exceeding a threshold,

wherein said weighting function has an attenuation coefficient determined such that a value of said peak of said calculated power values after said power limitation is equal to said threshold and that said calculated power values other than said peak in said weighting period are said threshold or less,

**characterized in that**

said predetermined periods are equal to T/2, and said weighting function F(t) is expressed as follows:

$$F(t) = 1 - A*\cos\,(\pi*(t-t_p)/T),\ \text{if}\ |t-t_p| \leq T/2,\ \text{and}$$
$$= 1,\ \text{if}\ |t-t_p| > T/2,$$

where T is said weighting period, A is said attenuation coefficient, $t_p$ is a time corresponding to a position of said peak.

2. The power limiting apparatus according to claim 1, wherein said function generating section detects peaks of said calculated power values exceeding a threshold, sets a weighting period provided for each of said peaks and obtained by adding predetermined periods before and after a position of each of said peaks of said calculated power values exceeding said threshold, generates a weighting function for each of said peaks, and generates said final weighting function through multiplication of said weighting functions F.

3. The power limiting apparatus according to claim 2, wherein said function generating section comprises:

  a power calculating circuit (203, 503) configured to calculate said power values;
  a window generating circuit (204) configured to determine said window period;
  a threshold setting circuit (205) configured to arbitrarily set said threshold;
  a maximum value detecting circuit (206) configured to detect said peaks of said calculated power values exceeding said threshold set by the threshold setting circuit; and
  a weighting function generating circuit (207) configured to determine said weighting functions and to generate said final weighting function by multiplying said weighting functions, and
  said delay operation section comprises:

    a delay circuit (208, 508) configured to delay said input signal by a time period of said weighting window; and
    a multiplying circuit (209, 509) configured to weight said delayed input signal delayed with said final weighting function.

4. The power limiting apparatus according to any of claims 1 to 3, wherein said input signal is a complex baseband signal.

5. The power limiting apparatus according to any of claims 1 to 3, wherein said input signal is an intermediate frequency signal.

6. A digital radio transmitter comprising said power limiting apparatus according to any of claims 1 to 5.

7. A digital radio base station comprising said digital radio transmitter according to claim 6.

8. A digital radio mobile station comprising said digital radio transmitter according to claim 6.

9. A power limiting method of an input signal, comprising:

  calculating power values from said input signal;
  determining a window period used to monitor said calculated power values;
  setting a threshold;
  detecting peaks from said calculated power values containing in said window period and exceeding said threshold;
  determining a final weighting function from said peaks and said threshold;
  delaying said input signal by said window period; and
  multiplying said final weighting function and said delayed input signal,

wherein said determining a final weighting function, comprises:
determining weighting functions for said peaks; and
multiplying said weighting functions to determine said final weighting function,
**characterized in that**

said predetermined periods are equal to T/2, and said weighting function F(t) is expressed as follows:

$$F(t) = 1 - A*\cos(\pi*(t-t_p)/T), \text{ if } |t-t_p| \le T/2, \text{ and}$$
$$= 1, \text{ if } |t-t_p| > T/2,$$

where T is said weighting period, A is said attenuation coefficient, $t_p$ is a time corresponding to a position of said peak.

10. The power limiting method according to claim 9, wherein said determining a final weighting function comprises:

determining said weighting period obtained by adding predetermined periods before and after a position of each of said peaks of said calculated power values exceeding said threshold.

**Patentansprüche**

1. Leistungsbegrenzungsvorrichtung umfassend:

einen Funktionserzeugungsteil (102a, 402a), der eingerichtet ist, Leistungswerte von einem Eingangssignal zu berechnen und eine finale Gewichtungsfunktion aus diesen berechneten Leistungswerten zu erzeugen; und
einen Verzögerungsberechnungsteil (102b, 402b), der eingerichtet ist, das Eingangssignal zu verzögern und, indem das verzögerte Eingangssignal mit der finalen Gewichtungsfunktion multipliziert wird, eine Leistungsbegrenzung auf das verzögerte Eingangssignal auszuführen,
wobei der Funktionserzeugungsteil die Gewichtungsfunktion für einen Gewichtungszeitraum erzeugt, der durch Addieren vorbestimmter Zeiträume vor und nach einer Position einer jeden Spitze der berechneten Leistungswerte, die einen Schwellwert überschreitet, gewonnen wird,
wobei die Gewichtungsfunktion einen Abschwächungskoeffizienten aufweist, der so bestimmt ist, dass ein Wert der Spitze der berechneten Leistungswerte nach der Leistungsbegrenzung gleich dem Schwellwert ist, und dass andere berechnete Leistungswerte als die Spitze im Gewichtungszeitraum den Schwellwert oder weniger betragen,
**dadurch gekennzeichnet, dass**
die vorbestimmten Zeiträume gleich T/2 betragen und die Gewichtungsfunktion F(t) ausgedrückt ist wie folgt:

$$F(t) = 1 - A * \cos(\pi*(t-t_p)/T), \text{ wenn } |t-t_p| \le T/2, \text{ und}$$
$$= 1, \text{ wenn } |t-t_p| > T/2,$$

wobei T der Gewichtungszeitraum ist, A der Abschwächungskoeffizient ist, $t_p$ ein Zeitpunkt entsprechend der Position der Spitze ist.

2. Leistungsbegrenzungsvorrichtung gemäß Anspruch 1, wobei der Funktionserzeugungsteil Spitzen der berechneten Leistungswerte, welche einen Schwellwert überschreiten, ermittelt, einen Gewichtungszeitraum festsetzt, der für jede der Spitzen vorgesehen ist und der durch Addieren vorbestimmter Zeiträume vor und nach der Position einer jeden der Spitzen der berechneten Leistungswerte, die den Schwellwert überschreiten, gewonnen wird, für jede der Spitzen eine Gewichtungsfunktion erzeugt, und die finale Gewichtungsfunktion durch Multiplikation der Gewichtungsfunktionen F erzeugt.

3. Leistungsbegrenzungsvorrichtung gemäß Anspruch 2,
wobei der Funktionserzeugungsteil umfasst:

eine Leistungsberechnungsschaltungsanordnung (203, 503), die eingerichtet ist, die Leistungswerte zu berech-

nen;
eine Fensterzeugungsschaltungsanordnung (204), die eingerichtet ist, den Fensterzeitraum zu bestimmen;
eine Schwellwertfestsetzschaltungsanordnung (205), die eingerichtet ist, den Schwellwert beliebig festzusetzen;
eine Maximalwertermittlungsschaltungsanordnung (206), die eingerichtet ist, die Spitzen der berechneten Leistungswerte, die den Schwellwert, der durch die Schwellwertfestsetzschaltungsanordnung festgesetzt wurde, überschreiten, zu ermitteln; und
eine Gewichtungsfunktionserzeugungsschaltungsanordnung (207), die eingerichtet ist, die Gewichtungsfunktionen zu bestimmen und die finale Gewichtungsfunktion durch Multiplizieren der Gewichtungsfunktionen zu erzeugen, und
der Verzögerungsbetriebsteil umfasst:

eine Verzögerungsschaltungsanordnung (208, 508), die eingerichtet ist, das Eingangssignal um einen Zeitraum des Gewichtungsfensters zu verzögern; und
eine Multiplizierschaltungsanordnung (209, 509), die eingerichtet ist, das verzögerte Eingangssignal mit der finalen Gewichtungsfunktion zu gewichten.

4. Leistungsbegrenzungsvorrichtung gemäß einem der Ansprüche 1 bis 3, wobei das Eingangssignal ein komplexes Basisbandsignal ist.

5. Leistungsbegrenzungsvorrichtung gemäß einem der Ansprüche 1 bis 3, wobei das Eingangssignal ein Zwischenfrequenzsignal ist.

6. Digitaler Funksender umfassend die Leistungsbegrenzungsvorrichtung gemäß einem der Ansprüche 1 bis 5.

7. Digitale Funkbasisstation umfassend den digitalen Funksender gemäß Anspruch 6.

8. Digitale Mobilfunkstation umfassend den digitalen Funksender gemäß Anspruch 6.

9. Verfahren zur Leistungsbegrenzung eines Eingangssignals umfassend:

Berechnen von Leistungswerten des Eingangssignals;
Ermitteln eines Fensterzeitraums, der zur Beobachtung der berechneten Leistungswerte verwendet wird;
Festsetzen eines Schwellwerts;
Ermitteln von Spitzen der berechneten Leistungswerte, die in dem Fensterzeitraum enthalten sind und den Schwellwert überschreiten;
Bestimmen einer finalen Gewichtungsfunktion aus den Spitzen und dem Schwellwert;
Verzögern des Eingangssignals um den Fensterzeitraum; und
Multiplizieren der finalen Gewichtungsfunktion und des verzögerten Eingangssignals,
wobei das Bestimmen der finalen Gewichtungsfunktion umfasst:
Bestimmen von Gewichtungsfunktionen der Spitzen; und
Multiplizieren der Gewichtungsfunktionen um die finale Gewichtungsfunktion zu bestimmen,
**dadurch gekennzeichnet, dass**
die vorbestimmten Zeiträume gleich T/2 sind, und die Gewichtungsfunktion F(t) ausgedrückt ist wie folgt:

$$F(t) = 1 - A * \cos\ (\pi * (t - t_p)/T),\ \text{wenn}\ |t - t_p| \leq T/2,\ \text{and}$$
$$= 1,\ \text{wenn}\ |t - t_p| > T/2,$$

wobei T der Gewichtungszeitraum ist, A der Abschwächungskoeffizient ist, $t_p$ ein Zeitpunkt ist, der einer Position der Spitze entspricht.

10. Verfahren zur Leistungsbegrenzung gemäß Anspruch 9, wobei das Bestimmen einer finalen Gewichtungsfunktion umfasst:

Bestimmen des Gewichtungszeitraums, der durch Addieren vorbestimmter Zeiträume vor und nach einer Position einer jeden der Spitzen der berechneten Leistungswerte, die den Schwellwert überschreiten, gewonnen wird.

**Revendications**

1. Appareil de limitation de puissance comprenant :

   une section de génération de fonction (102a, 402a) configurée pour calculer des valeurs de puissance d'un signal d'entrée et pour générer une fonction de pondération finale à partir desdites valeurs de puissance calculées ; et
   une section de calcul de retard (102b, 402b) configurée pour retarder ledit signal d'entrée et pour appliquer une limitation de puissance au signal d'entrée retardé en multipliant le signal d'entrée retardé par ladite fonction de pondération finale,
   dans lequel ladite section de génération de fonction génère ladite fonction de pondération pendant une période de pondération obtenue en ajoutant des périodes prédéterminées avant et après une position de chacun de pics desdites valeurs de puissance calculées dépassant un seuil,
   dans lequel ladite fonction de pondération a un coefficient d'atténuation déterminé de sorte qu'une valeur dudit pic desdites valeurs de puissance calculées après ladite limitation de puissance soit égale au dit seuil et que lesdites valeurs de puissance calculées autres que ledit pic pendant ladite période de pondération soient inférieures ou égales au dit seuil,

   **caractérisé en ce que**
   lesdites périodes prédéterminées sont égales à T/2, et ladite fonction de pondération F(t) est exprimée comme suit :

$$F(t) = 1 - A*\cos\ (\pi*(t-t_p)/T),\ si\ |t-t_p| \leq T/2,\ et$$
$$= 1,\ si\ |t-t_p| > T/2,$$

   où T est ladite période de pondération, A est ledit coefficient d'atténuation, $t_p$ est un temps correspondant à une position dudit pic.

2. Appareil de limitation de puissance selon la revendication 1, dans lequel ladite section de génération de fonction détecte des pics desdites valeurs de puissance calculées dépassant un seuil, fixe une période de pondération prévue pour chacun desdits pics et obtenue en ajoutant des périodes prédéterminées avant et après une position de chacun desdits pics desdites valeurs de puissance calculées dépassant ledit seuil, génère une fonction de pondération pour chacun desdits pics, et génère ladite fonction de pondération finale par une multiplication desdites fonctions de pondération F.

3. Appareil de limitation de puissance selon la revendication 2, dans lequel ladite section de génération de fonction comprend :

   un circuit de calcul de puissance (203, 503) configuré pour calculer lesdites valeurs de puissance ;
   un circuit de génération de fenêtre (204) configuré pour déterminer ladite période de fenêtre ;
   un circuit de détermination de seuil (205) configuré pour déterminer arbitrairement ledit seuil ;
   un circuit de détection de valeur maximum (206) configuré pour détecter lesdits pics desdites valeurs de puissance calculées dépassant ledit seuil déterminé par le circuit de détermination de seuil ; et
   un circuit de génération de fonction de pondération (207) configuré pour déterminer lesdites fonctions de pondération et pour générer ladite fonction de pondération finale en multipliant lesdites fonctions de pondération, et ladite section d'opération de retard comprend :

      un circuit à retard (208, 508) configuré pour retarder ledit signal d'entrée d'une période de temps de ladite fenêtre de pondération ; et
      un circuit de multiplication (209, 509) configuré pour pondérer ledit signal d'entrée retardé, retardé par ladite fonction de pondération finale.

4. Appareil de limitation de puissance selon l'une quelconque des revendications 1 à 3, dans lequel ledit signal d'entrée est un signal de bande de base complexe.

5. Appareil de limitation de puissance selon l'une quelconque des revendications 1 à 3, dans lequel ledit signal d'entrée est un signal de fréquence intermédiaire.

**6.** Emetteur radio numérique comprenant ledit appareil de limitation de puissance selon l'une quelconque des revendications 1 à 5.

**7.** Station radio de base numérique comprenant ledit émetteur radio numérique selon la revendication 6.

**8.** Station mobile radio numérique comprenant ledit émetteur radio numérique selon la revendication 6.

**9.** Procédé de limitation de puissance d'un signal d'entrée, comprenant :

le calcul de valeurs de puissance à partir dudit signal d'entrée ;
la détermination d'une période de fenêtre utilisée pour surveiller lesdites valeurs de puissance calculées ;
la détermination d'un seuil ;
la détection de pics à partir desdites valeurs de puissance calculées contenues dans ladite période de fenêtre et dépassant ledit seuil ;
la détermination d'une fonction de pondération finale à partir desdits pics et dudit seuil ;
le retard dudit signal d'entrée de ladite période de fenêtre ; et
la multiplication de ladite fonction de pondération finale et dudit signal d'entrée retardé, dans lequel ladite détermination d'une fonction de pondération finale, comprend :

la détermination de fonctions de pondération pour lesdits pics ; et
la multiplication desdites fonctions de pondération pour déterminer ladite fonction de pondération finale,
**caractérisé en ce que**
lesdites périodes prédéterminées sont égales à T/2, et ladite fonction de pondération F(t) est exprimée comme suit :

$$F(t) = 1 - A*\cos\left(\pi*(t-t_p)/T\right), \text{ si } |t-t_p| \leq T/2, \text{ et}$$
$$= 1, \text{ si } |t-t_p| > T/2,$$

où T est ladite période de pondération, A est ledit coefficient d'atténuation, $t_p$ est un temps correspondant à une position dudit pic.

**10.** Procédé de limitation de puissance selon la revendication 9, dans lequel ladite détermination d'une fonction de pondération finale comprend :

la détermination de ladite période de pondération obtenue en ajoutant des périodes prédéterminées avant et après une position de chacun desdits pics desdites valeurs de puissance calculées dépassant ledit seuil.

# Fig. 1

POWER LIMITING UNIT

101 — TRANSMISSION SIGNAL WAVEFORM SHAPING FILTER

100:TRANSMISSION SIGNAL

102 — DELAY CALCULATING SECTION — 102b

FUNCTION GENERATING SECTION — 102a

103 — ORTHOGONAL MODULATION UNIT

104 — FREQUENCY CONVERTING UNIT

105 — TRANSMISSION POWER AMPLIFYING UNIT

TRANSMISSION ANTENNA 106:

EP 1 569 350 B1

# Fig. 2

POWER LIMITING UNIT

201 : INPUT SIGNAL

(IN-PHASE SIGNAL)

(ORTHOGONAL SIGNAL)

102

208 DELAY CIRCUIT

209

(IN-PHASE SIGNAL)

(ORTHOGONAL SIGNAL)

202 : OUTPUT SINGAL

203 — POWER CALCULATING CIRCUIT

Pi

MAXIMUM VALUE DETECTING CIRCUIT

Pp, tp ts, te

WEIGHTING FUNCTION GENERATING CIRCUIT

207

205 — THRESHOLD SETTING CIRCUIT

Pth

206

WINDOW GENERATING CIRCUIT

204

EP 1 569 350 B1

# Fig. 3A

INPUT POWER Pi

MAXIMUM P

MAXIMUM VALUE Pp

THRESHOLD Pth

INPUT Pi(t)

ts  tp  te

WINDOW (Tw)

TIME t

# Fig. 3B

OUTPUT POWER Po

OUTPUT IN NON-LIMITED POWER CASE

MAXIMUM P

OUTPUTPo(t)

THRESHOLD Pth

MAXIMUM VALUE Pp'

WEIGHTING FUNCTION F(t)

TIME t

WEIGHTING PERIOD (T)

DELAY TIME (Tw)

WINDOW (Tw)

# Fig. 4

EP 1 569 350 B1

TRANSMISSION ANTENNA
106:

100:TRANSMISSION SIGNAL

| 101 | 103 | 402 | 104 | 105 |
|---|---|---|---|---|
| TRANSMISSION SIGNAL WAVEFORM SHAPING FILTER | ORTHOGONAL MODULATION UNIT | POWER LIMITING UNIT | FREQUENCY CONVERTING UNIT | TRANSMISSION POWER AMPLIFYING UNIT |

POWER LIMITING UNIT

DELAY CALCULATING SECTION

402b

FUNCTION GENERATING SECTION

402a

# Fig. 5

501: INPUT SIGNAL (INTERMEDIATE FREQUENCY SIGNAL)

502: OUTPUT SINGAL (INTERMEDIATE FREQUENCY SIGNAL)

402 POWER LIMITING UNIT

508 DELAY CIRCUIT

509

207 WEIGHTING FUNCTION GENERATING CIRCUIT

204 WINDOW GENERATING CIRCUIT

206 MAXIMUM VALUE DETECTING CIRCUIT

503 POWER CALCULATING CIRCUIT

205 THRESHOLD SETTING CIRCUIT

Pi

Pth

Pp, tp, ts, te

# Fig. 6A

INPUT POWER Pi

MAXIMUM P0    MAXIMUM P1

MAXIMUM VALUE Ppı
MAXIMUM VALUE Ppo
THRESHOLD Pth

INPUTPi (t)

tso tpo teo    tsı teı
tpı

WINDOW (Tw)

TIME t

# Fig. 6B

OUTPUT POWER Po

OUTPUT IN CASE OF NON-LIMITED POWER

MAXIMUM P0    MAXIMUM P1

THRESHOLD
Pth

OUTPUT Po (t)

MAXIMUM VALUE
Ppo'

MAXIMUM
VALUE
Ppı'

WEIGHTING
FUNCTION F(t)

WEIGHTING PERIOD
(To)

WEIGHTING PERIOD
(Tı)

TIME t

DELAY TIME (Tw)    WINDOW (Tw)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEISEI1188257 A
- JP HEISEI11136210 A
- JP HEISEI11274983 A
- JP P2000106548 A
- JP P2000244452 A
- JP P200186094 A
- JP P2001285088 A
- JP P2001298409 A
- JP P2001339361 A
- WO 0033477 A1